Europäisches Patentamt

European Patent Office

Office européen des brevets

(19)

(11) Numéro de publication : **0 092 266**
**B1**

# (12) FASCICULE DE BREVET EUROPÉEN

(45) Date de publication du fascicule du brevet :
21.01.87

(21) Numéro de dépôt : 83200486.5

(22) Date de dépôt : 06.04.83

(51) Int. Cl.⁴ : **H 01 L 21/265**, H 01 L 29/10,
H 01 L 29/80, H 01 L 29/207

(54) **Procédé de fabrication de transistors à effet de champ, en GaAs, par implantations ioniques et transistors ainsi obtenus.**

(30) Priorité : 09.04.82 FR 8206290

(43) Date de publication de la demande :
26.10.83 Bulletin 83/43

(45) Mention de la délivrance du brevet :
21.01.87 Bulletin 87/04

(84) Etats contractants désignés :
DE FR GB NL

(56) Documents cités :
EP-A- 0 057 605
FR-A- 2 358 751
FR-A- 2 513 439
PROCEEDINGS 8TH BIENNIAL CORNELL ELECTRI-
CAL ENGINEERING CONFERENCE,11-13 août 1981,
pages 233-241, New York, USA, DENG XIAN-CAN et
al.: "A 12 GHz planar low-noise GaAs MESFET"
JAPANESE JOURNAL OF APPLIED PHYSICS, vol. 16,
no. 16-1, 1977, supplément 16-1, pages 111-114,
Tokyo, JP., T. NOZAKI et al.: "Sub-micron gate GaAs
MESFET's with ion-implanted channels"
ELECTRONICS LETTERS, vol.15, no. 9, 26 avril 1979,
pages 245-247, Hitchin, G.B., H. BRUCH et al.:"VPE
GaAs MESFET structure using oxygen injection
during buffer layer growth"
ELECTRONICS LETTERS, vol. 17, no. 23, 12 novembre
1981, pages 873-874, Londres, G.B., M. BERTH et al.:
"Selective carrier removal using oxygen implantation
in GaAs"
PROCEEDINGS 7TH BIENNIAL CORNELL ELECTRI-
CAL ENGINEERING CONFERENCE, 14-16 août 1979,
pages 121-130, New York, USA, H.B. KIM et al.:
"Encapsulant and controlled atmosphere annealing
of ion implanted GaAs"

(73) Titulaire : **Laboratoires d'Electronique et de Physique
Appliquée L.E.P.**
**3, Avenue Descartes**
**F-94450 Limeil-Brévannes (FR)**
**FR**
**N.V. Philips' Gloeilampenfabrieken**
**Groenewoudseweg 1**
**NL-5621 BA Eindhoven (NL)**
**DE GB NL**

(72) Inventeur : **Martin, Gérard Marie**
**Société Civile S.P.I.D 209 rue de l'Université**
**F-75007 Paris (FR)**
Inventeur : **Makram-Ebeid, Shérif**
**Société Civile S.P.I.D 209 rue de l'Université**
**F-75007 Paris (FR)**
Inventeur : **Venger, Camille**
**Société Civile S.P.I.D 209 rue de l'Université**
**F-75007 Paris (FR)**

(74) Mandataire : **Landousy, Christian et al**
**Société Civile S.P.I.D. 209, Rue de l'Université**
**F-75007 Paris (FR)**

## Description

L'invention concerne un procédé de fabrication d'un transistor à effet de champ dans une couche en arséniure de gallium N-type sur un substrat d'arséniure de gallium semi-isolant obtenu par découpe d'une plaquette dans un lingot massif. L'invention concerne également des transistors à effet de champ obtenus par la mise en œuvre de ce procédé.

L'invention est relative à l'industrie des circuits intégrés, plus spécifiquement sur arséniure de gallium. L'élément unitaire essentiel de ces circuits est le transistor à effet de champ dont la grille de commande est le plus souvent une électrode métallique en contact avec une couche semiconductrice, formant une jonction dite de Schottky.

Un procédé de fabrication d'un composant à semi-conducteur comportant un contact Schottky est connu de la demande de brevet français FR-A-2 358 751. Selon le procédé décrit dans ce document, on dope par implantations d'ions une couche jouxtant la face supérieure d'un semi-conducteur de forte valeur ohmique. Notamment, on peut obtenir en surface d'un substrat semi-isolant en arséniure de gallium, la couche active d'un composant comportant un contact Schottky, par implantation d'ions choisis parmi Si, S, Se et Te, suivie d'un recuit.

L'objectif de la microélectronique étant la réduction de volume et de poids, pour des applications où celle-ci est primordiale, à savoir le domaine aérospatial, cette réduction passe nécessairement par une intégration de plus en plus poussée des circuits. Cependant des anomalies dans les performances des transistors limitent le rendement de fabrication de ces circuits et s'opposent à l'amélioration du niveau d'intégration.

Parmi ces anomalies, il en est deux particulières qui semblent être les moins bien comprises et les plus gênantes.

Il s'agit du phénomène de commande par le substrat (dit « back-gating » en anglo-saxon) et des anomalies des caractéristiques drain-source $I_{DS}$-$V_{DS}$ (dit « bumping »).

Le premier phénomène consiste en la possibilité de commander le canal d'un transistor à effet de champ (TEC) à partir d'une électrode voisine mais étrangère audit transistor, soumise à un potentiel négatif par rapport à la source de ce même transistor. Ce type d'anomalie était connu sur les transistors obtenus par épitaxie, et une solution à ce problème consiste à élaborer une couche tampon faiblement conductrice de façon à séparer le canal du transistor et le substrat semi-isolant. Cette solution n'est pas transposable ici, puisque la technologie envisagée pour la fabrication des transistors consiste en implantation(s) directe(s) dans un substrat de GaAs semi-isolant.

Le second phénomène consiste en un brusque accroissement du courant de drain, à partir d'une certaine tension de seuil entre le drain et la source. L'origine de ce phénomène semble être étroitement associée à celui de la commande par le substrat, car les deux phénomènes se trouvent de façon concomitante dans un même transistor à effet de champ.

L'invention a pour but de pallier ces divers inconvénients en proposant un nouveau procédé de fabrication, propre à diminuer ces phénomènes parasites, dans lequel la couche d'arséniure de gallium N-type est obtenue par implantation d'ions de Si et Se dans ledit substrat d'arséniure de gallium semi-isolant, et dans lequel afin de freiner l'exodiffusion de niveaux profonds donneurs l'on implante également, au moins dans la région du substrat destinée à former la région de canal dudit transistor à effet de champ, des ions d'oxygène, après quoi l'on effectue un recuit à une température comprise entre 600 °C et 900 °C.

La description qui va suivre, en regard des dessins annexés donnés à titre non limitatif, permettra de mieux comprendre comment l'invention s'exécute et se poursuit, et de mieux en apprécier la portée.

Les figures 1 et 2 représentent les étapes d'implantations ioniques dans un substrat de GaAs.

La figure 3 représente les profils de concentration d'un niveau profond ($EL_2$), après recuit, selon l'art antérieur et selon la présente invention, pour comparaison.

La figure 4 représente la fabrication des transistors à effet de champ (TEC), sur le substrat obtenu, après traitement conforme à la présente invention.

Selon l'art antérieur, la réalisation des dispositifs semi-conducteurs tels que les transistors à effet de champ s'effectuait usuellement par les techniques de croissance épitaxiale et d'auto-alignement.

L'épitaxie est un procédé qui désigne la croissance orientée d'une couche monocristalline, sur un substrat lui-même monocristallin. Elle permet notamment de déposer une (ou plusieurs) couche(s) d'épaisseur et de dopage parfaitement contrôlés, sur un substrat de qualité inférieure, par exemple une plaquette découpée dans un lingot massif d'un semi-conducteur, tel que l'arséniure de gallium.

Par la suite, par exemple avec la technologie dite d'auto-alignement, propre à réaliser des transistors à effet de champ à grille Schottky, telle que divulguée initialement dans le brevet français n° 1 437 781, déposé au nom de la N.V. Philips' Gloeilampenfabrieken, les principales étapes sont les suivantes :

a) dépôt d'une couche métallique destinée à l'électrode de grille ;

b) dépôt de résine photosensible et illumination aux rayons ultraviolets à travers un masque délimitant ladite électrode de grille ;

c) gravure de la couche métallique et sous-gravure du matériau semi-conducteur au moyen d'une solution appropriée ;

d) dépôt d'une couche métallique formant contact ohmique avec le matériau semi-conducteur destiné à devenir les électrodes de source et de drain en profitant de l'effet d'ombre obtenu par la sous-gravure de l'étape précédente.

Diverses variantes et améliorations sont connues, mais ne sont pas décrites ici, plus en détail, comme ne faisant pas partie à proprement dit de l'invention.

Lors de la réalisation de circuits intégrés par multiplication de ce motif essentiel qu'est le transistor à effet de champ (TEC) sur un même substrat, il apparaît à partir d'un certain degré d'intégration des anomalies de fonctionnement, relativement gênantes, dont deux particulières sus-citées, à savoir la commande par le substrat et les anomalies des caractéristiques $I_{DS}$-$V_{DS}$ dans les TEC. Ces types d'anomalies ont été étudiés sur les transistors élaborés par épitaxie, et l'on citera pour mémoire l'article paru dans IEEE Transaction on electronic devices, ED-27, 1037 (1980) par T. Itoh et H. Yanai qui a conclu notamment que les niveaux profonds jouent un rôle important dans la formation de ces anomalies.

La solution retenue pour ce type de transistor — couche tampon faiblement conductrice — n'étant pas applicable dans le cas de transistors élaborés par implantation(s) ionique(s) directe(s) dans un substrat semi-isolant, la Demanderesse a donc été conduite à explorer de façon plus précise l'état des niveaux profonds dans les substrats semi-isolants, à déterminer un mécanisme de perturbation par les électrodes voisines, propre à assurer une bonne compréhension de ces phénomènes et à en déduire un procédé nouveau visant à pallier les susdits inconvénients.

Une des premières étapes de cette recherche fondamentale a été conduite par G. M. Martin, A. Mitonneau et A. Mircea et publiée dans Electronics Letters, 31 Mars 1977, Vol. 13, N° 7, p. 191-193, sous l'article intitulé « Electron traps in bulk and epitaxial GaAs crystals ». Le but de cette étude consistait notamment à répertorier les différents niveaux des pièges électroniques, à les caractériser et à en dresser un inventaire en fonction par exemple de leurs énergies d'activation.

Une seconde étape a consisté à comprendre les mécanismes de compensation propres à rendre un matériau semi-isolant. L'article intitulé « Compensation mechanisms in GaAs », de G. M. Martin, J. P. Farges, G. Jacob, J. P. Hallais et G. Poiblaud, paru dans J. Applied physics, (51), 5 Mai 1980, p. 2840-2852, fait typiquement le point des connaissances actuelles de ce mécanisme, il conclut notamment que la compensation provient de deux niveaux profonds, un premier niveau profond donneur dit EL2 ($E_C$-0,75 eV) et un second niveau profond accepteur, relatif au chrome, dans le cas de matériau massif d'arséniure de gallium, intentionnellement dopé au chrome, dans des concentrations qui peuvent varier entre $6 \cdot 10^{15}$ et $4 \cdot 10^{17}$ cm$^{-3}$. Les diagrammes de Shockley permettent alors de déduire, à partir des niveaux des accepteurs et des donneurs, la position du niveau de Fermi $E_F$, qui rappelons-le, est situé au milieu de la bande interdite, pour les matériaux semi-isolants, et donc fortement dépendant des deux niveaux profonds sus-cités.

Dans la suite du présent mémoire il convient de rappeler ce que l'on entend par exodiffusion et les inconvénients qui y sont attachés. Par exodiffusion, on entend qu'à la suite d'un chauffage la densité du niveau chute à la surface du matériau, mais reste pratiquement constante en son volume. Le niveau $EL_2$ étant un niveau profond donneur ($E_C$-0,75 eV), son exodiffusion conduit donc à une conversion en surface en un matériau de type p. Or, lorsqu'on élabore des dispositifs semi-conducteurs de type TEC, dans le GaAs, on implante des donneurs ($Se^+$ ou $Si^+$) de façon à obtenir une couche de type de conductivité n, mais la profondeur d'implantation — environ 150 nm — est bien inférieure à la distance de la conversion — environ 1 000 nm — et on obtient donc une jonction parasite à l'arrière du dispositif qui semble être responsable des anomalies de commande parasite par les électrodes voisines.

La Demanderesse a donc cherché un procédé de traitement de la région du substrat, destiné à former la région de grille du TEC, permettant de freiner l'exodiffusion du niveau $EL_2$, de façon à diminuer l'étendue de conversion et par la même de diminuer les phénomènes parasites de commande par le substrat.

Conformément à la présente invention, on implante également, au moins dans la région du substrat destinée à former la région de canal dudit transistor à effet de champ, des ions oxygène.

En effet, il apparaît des expériences conduites par la Demanderesse que l'implantation d'oxygène freine dans une notable mesure l'exodiffusion du niveau $EL_2$. En outre, cette exodiffusion étant très sensible au type de matériau utilisé, en freinant cette exodiffusion, on réduit l'écart entre les divers matériaux ainsi implantés, et on rend donc plus reproductible la technologie de fabrication.

Le procédé de fabrication des transistors à effet de champ selon l'invention sera maintenant décrit, en référence aux figures ci-annexées.

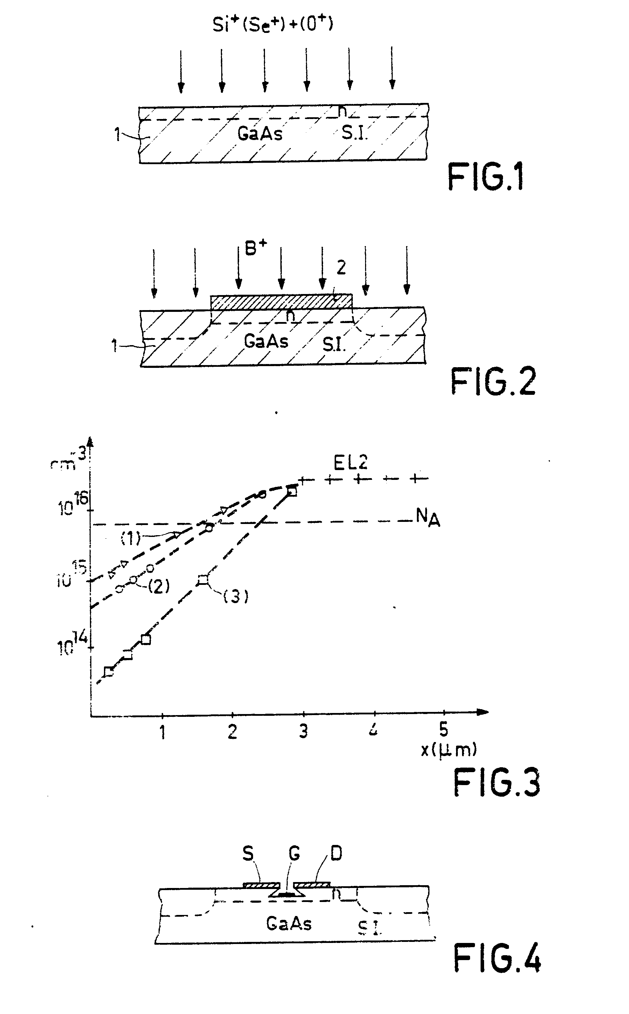

La figure 1 représente un substrat de GaAs semi-isolant, obtenu par découpe d'une plaquette dans un lingot massif, tel qu'obtenu par tirage. Dans ce substrat, il est implanté des atomes donneurs tels que le silicium ($Si^+$) ou le sélénium ($Se^+$) de façon à obtenir une couche de type de conductivité n. Conformément à l'invention, on implante alors également de l'oxygène ($O^+$), les conditions d'implantation dépendant de la nature du précédent implant :

a) dans le cas d'implantations de sélénium ($Se^+$) et d'oxygène ($O^+$), ceux-ci sont implantés aux mêmes endroits, par exemple avec des énergies et des doses Se$^+$ : (280 keV ; $3 \times 10^{12}$ cm$^{-2}$) et O$^+$ : (100 keV ; de $5 \times 10^{11}$ à $5 \times 10^{13}$ cm$^{-2}$) ;

b) dans le cas d'implantations de silicium (Si$^+$) et d'oxygène (O$^+$), on implante le premier avec plusieurs énergies de façon à avoir une couche très épaisse, par exemple Si$^+$ : 60 keV, 200 keV et 400 keV, et le dernier avec une assez grande énergie de façon à ce qu'il soit implanté assez profondément, par exemple O$^+$ : 200 keV, les doses étant sensiblement les mêmes que celles citées ci-dessus.

En effet, dans le cadre de la présente invention, l'implantation d'ions d'oxygène (O$^+$) s'effectue dans la région destinée à devenir la région de grille, alors qu'en outre, si l'autre implant choisi est le silicium (Si$^+$), l'énergie d'implantation est choisie de telle sorte que les implants oxygène soient relativement profonds (par exemple à une profondeur comprise entre 400 nm et 800 nm), les implants silicium (Si$^+$) étant répartis dans une couche d'épaisseur relativement importante (par exemple depuis la surface jusqu'à 1 000 nm) qui recouvre au moins partiellement cette première.

La figure 2 représente l'étape d'isolation par caisson des éléments fondamentaux. Elle s'effectue selon une technologie connue d'implantation ionique de Bore (B$^+$), les zones à protéger étant recouvertes par exemple d'une couche de laque de quelques microns d'épaisseur.

Ces implantations ioniques sont alors suivies d'un traitement thermiqjue sous encapsulant, par exemple sous nitrure de silicium, à une température comprise entre 800 °C et 900 °C, pendant un temps de l'ordre de 15 minutes. Cette étape de recuit est nécessaire pour guérir les défauts d'implantation et amener en site substitutionnel les ions introduits dans la matrice cristalline. Cette étape de recuit est également importante puisqu'elle modifie les profils de concentration et notamment l'exodiffusion des niveaux profonds, tels que EL$_2$ ou celui du Chrome Cr.

Selon une variante, le recuit peut se faire sous atmosphère d'arsine, le substrat étant nu.

Les résultats obtenus, pour les expériences conduites par la Demanderesse, après implantation d'oxygène, sont particulièrement intéressants : l'exodiffusion de EL$_2$ est beaucoup moins rapide que celle observée pour ce même niveau pour des recuits classiques sous encapsulant.

La figure 3 représente le profil de concentration (x étant la distance depuis la surface) du niveau EL$_2$ dans un substrat de GaAs. Les courbes (1 et 2) représentent ce profil dans un substrat de type n obtenu par implantations ioniques de Se$^+$ ($3.5 \times 10^{12}$ cm$^{-2}$, 280 keV) et O$^+$ ($10^{14}$ cm$^{-2}$ pour la courbe 1, $10^{13}$ cm$^{-2}$ pour la courbe 2, à 100 keV) et recuit à 870 °C sous Si$_3$N$_4$. La courbe (3) représente ce profil pour un même substrat sans implantation d'oxygène. N$_A$ est la densité des accepteurs.

La figure 4 représente alors la formation des éléments fondamentaux (TEC), selon une technologie également connue, qui permet d'obtenir des grilles submicroniques, sans masque submicronique par une sous-gravure de l'électrode de drain, étant bien entendu que toute autre technologie compatible peut être également utilisée.

Il est bien évident pour l'homme de l'art que de nombreuses variantes peuvent être imaginées sans pour cela faire œuvre d'esprit, donc sans sortir du cadre de la présente invention tel que défini par les revendications ci-après annexées.

**Revendications**

1. Procédé de fabrication d'un transistor à effet de champ dans une couche en arséniure de gallium N-type sur un substrat d'arséniure de gallium semi-isolant obtenu par découpe d'une plaquette dans un lingot massif, dans lequel la couche d'arséniure de gallium N-type est obtenue par implantation d'ions de Si ou de Se dans ledit substrat d'arséniure de gallium semi-isolant, et dans lequel afin de freiner l'exodiffusion de niveaux profonds donneurs l'on implante également, au moins dans la région du substrat destinée à former la région de canal dudit transistor à effet de champ, des ions d'oxygène après quoi on effectue un recuit à une température comprise entre 600 °C et 900 °C.

2. Procédé selon la revendication 1, caractérisé en ce que les ions donneurs sont des ions de sélénium et que les ions d'oxygène sont implantés approximativement à la même profondeur que les ions de sélénium.

3. Procédé selon la revendication 1, caractérisé en ce que les ions d'oxygène sont implantés à une profondeur déterminée et que des ions de silicium sont implantés avec plusieurs énergies de façon à produire, depuis la surface, une répartition d'ions de silicium sur une couche qui recouvre au moins partiellement la zone implantée d'ions oxygène.

4. Procédé selon la revendication 3, caractérisé en ce que la couche implantée de silicium s'étend jusqu'à une profondeur de 1 000 nm et que les ions d'oxygène sont implantés à une profondeur entre 400 et 800 nm.

5. Procédé selon l'une des revendications 1 à 4, caractérisé en ce que, lors du traitement thermique, le substrat est encapsulé sous du nitrure de silicium.

6. Procédé selon l'une des revendications 1 à 4, caractérisé en ce que le traitement thermique est effectué sous atmosphère d'arsine, le substrat étant nu.

**Claims**

1. A method of manufacturing a field effect transistor in a layer of n-type gallium arsenide on a substrate of semi-insulating gallium arsenide obtained by cutting a wafer from a solid ingot, in which the layer of n-type gallium arsenide is obtained by implantation of Si or Se donor ions in said substrate of semi-insulating gallium arsenide and in which, in order to inhibit the outdiffusion of deep donor levels, oxygene ions are also implanted at least at the area of the substrate intended to form the channel region of said field effect transistor, after which a thermal treatment is carried out at a temperature between 600 °C and 900 °C.

2. A method as claimed in Claim 1, characterized in that the donor ions are selenium ions and in that the oxygen ions are implanted approximately to the same depth as the selenium ions.

3. A method as claimed in Claim 1, characterized in that the oxygen ions are implanted to a given depth and in that silicon ions are implanted with several energies in order to obtain, reckoned from the surface, a distribution of silicon ions over a layer covering at least in part the zone in which oxygen ions are implanted.

4. A method as claimed in Claim 3, characterized in that the layer in which silicon is implanted extends down to a depth of 1 000 nm and in that the oxygen ions are implanted to a depth between 400 and 800 nm.

5. A method as claimed in any one of Claims 1 to 4, characterized in that during the thermal treatment the substrate is enveloped in silicon nitride.

6. A method as claimed in any one of Claims 1 to 4, characterized in that the thermal treatment is carried out in an atmosphere of arsine, the substrate being uncovered.

## Patentansprüche

1. Verfahren zur Herstellung eines Feldeffekttransistors in einer n-leitenden Galliumarsenidschicht auf einem halbisolierenden Substrat aus Galliumarsenid, das dadurch erhalten worden ist, dass eine Platte von einer massiven Stab geschnitten wird, wobei die n-leitende Galliumarsenidschicht durch Implantation von Si- oder Selonen in dem genannten halbisolierenden Galliumarsenidsubstrat erhalten worden ist und wobei, zum Abbremsen der Aus-diffusion von tiefen Donorpegel, ausserdem wenigstens in demjenigen Gebiet des Substrates, das dazu bestimmt ist, das Kanalgebiet des genannten Feldeffekttransistors zu bilden, Sauerstoffionen implantiert werden, wonach eine Glühbehandlung bei einer Temperatur, die zwischen 600 °C und 900 °C wird.

2. Verfahren nach Anspruch 1, dadurch gekennzeichnet, dass die Donorionen Selenionen sind und dass die Sauerstoffionen in nahezu derselben Tiefe wie die Selenionen implantiert werden.

3. Verfahren nach Anspruch 1, dadurch gekennzeichnet, dass die Sauerstoffionen in einer bestimmten Tiefe implantiert werden, und dass die Siliziumionen mit verschiedenen Energien implantiert werden, so dass, ausgehend von der Oberfläche, eine Verteilung der Siliziumionen über eine Schicht erhalten wird, die wenigstens teilsweise die Zone, in der Sauerstoffionen implantiert worden sind umfasst.

4. Verfahren nach Anspruch 3, dadurch gekennzeichnet, dass die mit Silizium implantierte Schicht sich bis zu einer Tiefe von 1 000 nm erstreckt und dass die Sauerstoffionen in einer Tiefe zwischen 400 und 800 nm implantiert werden.

5. Verfahren nach einem der Ansprüche 1 bis 4, dadurch gekennzeichnet, dass das Substrat während der thermischen Behandlung in Siliziumnitrid eingekapselt wird.

6. Verfahren nach einem der Ansprüche 1 bis 4, dadurch gekennzeichnet, dass die thermische Behandlung in einer Arsinatmosphere durchgeführt wird, wobei das Substrat unbedeckt ist.

$Si^+ (Se^+) + (0^+)$

1

n

GaAs   S.I.

## FIG.1

$B^+$

2

n

1

GaAs   S.I.

## FIG.2

$cm^{-3}$

EL2

$10^{16}$

$N_A$

(1)

$10^{15}$

(2)

(3)

$10^{14}$

1   2   3   4   5

$x(\mu m)$

## FIG.3

S   G   D

GaAs   S.I.

## FIG.4